# EUROPÄISCHE PATENTSCHRIFT

(11) **EP 0 731 113 B1**
(45) Veröffentlichungstag und Bekanntmachung des Hinweises auf die Patenterteilung: **13.01.1999**
(21) Anmeldenummer: 96102835.4
(22) Anmeldetag: 26.02.1996
(51) Int. Cl.: C08F 20/60, G03F 7/033

(54) **Polymere und damit hergestelltes lichtempfindliches Gemisch**
Polymers and photosensitive compositions obtained therefrom
Polymères et compositions photosensibles formées à partir de ceux-ci

(30) Priorität: 04.03.1995 DE 19507618
(43) Veröffentlichungstag der Anmeldung: 11.09.1996
(73) Patentinhaber: Agfa-Gevaert AG, 51373 Leverkusen (DE)
(72) Erfinder: Eichhorn, Mathias, Dr., D-65527 Niedernhausen (DE); Elsässer, Andreas, Dr., D-65510 Idstein (DE)

(56) Entgegenhaltungen:
- CHEMICAL ABSTRACTS, Band 112, Nr. 24, 11. Juni 1990, Columbus, Ohio, USA K. AOSHIMA "Negative-Working Photosensitive Compositions" Seite 679, Nr. 226 829v; & JP-A-01 284 849
- CHEMICAL ABSTRACTS, Band 114, Nr. 2, 14. Januar 1991, Columbus, Ohio, USA M. IMAI "Photosensitive Compositions" Seite 566, Nr. 14 958c; & JP-A-02 189 547
- BULLETIN OF THE CHEMICAL SOCIETY OF JAPAN, Band 61, Nr. 10, Oktober 1988 K. KURITA "Addition of N-(Hydroxymethyl)phthalimide to Methacrylates by Carbon- -Carbon Bond Formation" Seiten 3755-3757

## Beschreibung

Die Erfindung betrifft Polymere, die als Bindemittel für lichtempfindliche Gemische auf Basis von 1,2-Chinondiaziden geeignet sind. Die Gemische werden insbesondere zur Herstellung von Flachdruckplatten verwendet, die sowohl direkt zu Positiv- als auch durch Umkehrentwicklung zu Negativdruckplatten verarbeitet werden können.

Lichtempfindliche Gemische der genannten Gattung, die durch Belichten in Entwicklern, insbesondere wäßrig-alkalischen Lösungen, löslich werden, sind bekannt.

Ein wesentlicher Teil der Eigenschaften der mit diesen Gemischen erhaltenen Aufzeichnungsmaterialien wird vom mengenmäßigen Hauptbestandteil des strahlungs- bzw. lichtempfindlichen Gemischs, dem Bindemittel, bestimmt. Als Bindemittel für Positiv-Kopiermaterialien werden praktisch ausschließlich Phenol-oder Kresol-Formaldehyd-Kondensationsprodukte vom Novolaktyp eingesetzt.

Für einige Anwendungen von Positivdruckplatten sind jedoch die daraus resultierenden Eigenschaften noch nicht optimal. Dies betrifft insbesondere die Höhe der Druckauflage und die Stabilität der lichtempfindlichen Schichten gegen Wasch- und Reinigungsmittel, die im Drucksaal eingesetzt werden. Vor allem beim Drucken mit Druckfarben, die im UV-Licht aushärten, werden Auswaschmittel eingesetzt, die einen hohen Gehalt an Lösemitteln wie Ethern, Estern oder Ketonen aufweisen oder allein aus solchen Lösemitteln bestehen und dadurch zu einer starken Schädigung der Kopierschichten führen.

Bei Schichten mit Novolaken als Bindemittel ist es daher unerläßlich, vor dem Drucken mit diesen Farben bzw. für Auflagenleistungen von mehr als ca. 100 000 Drucken eine thermische Härtung der Kopierschichten bei Temperaturen über 200 °C vorzunehmen.

Es wurden verschiedene Bindemittel mit verbesserten Eigenschaften vorgeschlagen. Phenolharze auf Naphtholbasis sind in der US-A 4 551 409 als alkalilösliche Bindemittel für Positiv-Kopiermaterialien beschrieben, Homo-und Copolymerisate von Vinylphenolen in den DE-A 23 22 230 (= US-A 3 869 292) und DE-A 34 06 927 (= US-A 4 678 737), Polymerisate der Ester von Acrylsäuren mit Phenolen in der JP-A 76/36 129, den EP-A 0 212 440 und EP-A 0 212 439 sowie Copolymerisate von N-Hydroxyphenyl-maleimiden in der EP-A 0 187 517. Ferner wurden genannt: Homo- und Copolymerisate von Hydroxybenzylacrylamiden in der DE-A 38 20 699 (= US-A 5 068 163), Homo- und Copolymerisate von Hydroxybenzylacrylestern in der DE-A 40 02 397 (US-A 5 275 908), Homo- und Copolymerisate von Hydroxyphenylacrylamiden in der JP-A 75/55 406 (= JP-B 77/28 401), Copolymerisate mit Halogenmethyleinheiten in der EP-A 0 440 086, Homo- und Copolymerisate mit NH-aciden Einheiten sind in der DE-A 37 42 387 und den EP-A 0 330 239 und EP-A 0 544 264 beschrieben.

Mit Ausnahme der genannten Polymerisate mit Hydroxyphenylacrylamiden bzw. NH-aciden Einheiten hat keine der vorgeschlagenen Novolak-Alternativen bislang eine praktische Anwendung gefunden. Die Gründe hierfür sind schlechteres Entwicklungsverhalten, höherer Entwicklerverbrauch, Beeinträchtigung des Belichtungskontrastes und schlechte synthetische Zugänglichkeit der Monomere. Von den beiden Bindemitteltypen, die Eingang in die praktische Anwendung gefunden haben, ist der erste generell unbefriedigend in der Resistenz gegen Lösemittel enthaltende Reinigungsmittel und der zweite Typ auch nach einer thermischen Behandlung nicht gegen alle derartigen Reinigungsmittel ausreichend stabil.

Es war daher Aufgabe der Erfindung, ein lichtempfindliches Gemisch auf Basis von 1,2-Chinondiaziden und neuen polymeren Bindemitteln für ein Aufzeichnungsmaterial vorzuschlagen, mit dem Flachdruckplatten mit höherer Druckauflagenleistung und besserer Reinigungsmittelbeständigkeit als bekannte Materialien erhalten werden können und das sonst im wesentlichen gleiche Verarbeitungseigenschaften aufweist wie entsprechende bekannte Gemische.

Erfindungsgemäß wird ein Polymer mit wiederkehrenden Einheiten der allgemeinen Formel I 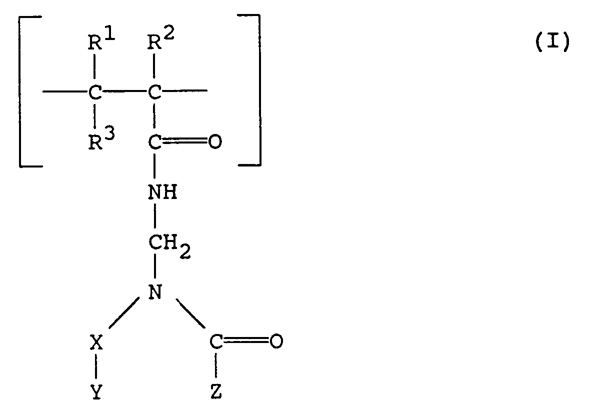 vorgeschlagen, worin
- R¹,R² und R³: unabhängig voneinander Wasserstoffatome oder Alkylgruppen sind,
- X: CO oder SO₂ ist und
- Y und Z: unabhängig voneinander Alkyl-, Alkenyl-, Cycloalkyl-, Aryl- oder (un)gesättigte heterocyclische Reste bedeuten, wobei Y und Z miteinander verknüpft und Bestandteile eines fünf- oder sechsgliedrigen heterocyclischen Rings sein können.

Wenn R¹, R² und/oder R³ Alkylgruppen sind, dann enthalten sie bevorzugt jeweils nicht mehr als 4 Kohlenstoffatome und sind bevorzugt nicht verzweigt. In der allgemeinen Formel I sind R¹ und R³ jedoch bevorzugt Wasserstoffatome. R² ist bevorzugt ein Wasserstoffatom oder eine Methylgruppe. Y und Z enthalten vorzugsweise jeweils nicht mehr als 20 Kohlenstoffatome. Wenn sie miteinander verknüpft sind, dann sind sie bevorzugt Bestandteile eines fünfgliedrigen Rings, an den gegebenenfalls ein weiterer Ring, bevorzugt ein Benzolring, anelliert ist. Die ungesättigten heterocyclischen Reste Y und/oder Z sind bevorzugt Heteroarylreste.

Die den Einheiten der Formel I Zugrundeliegenden Monomere der Formel II sind in einfacher Weise Zugänglich durch die Ritter-Reaktion [K. I. Krimen, J. Cota, Org. React. 17 (1969) 213], d. h. die säurekatalysierte Umsetzung ungesättigter Nitrile mit N-Hydroxymethylimiden nach folgender Gleichung:

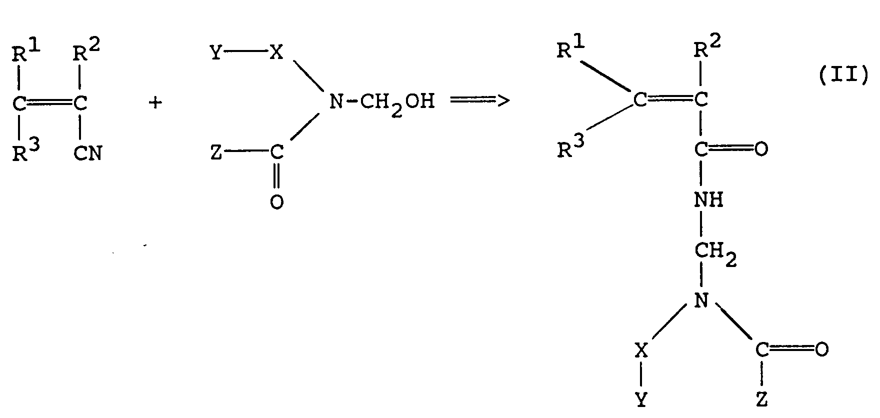

Die Synthese ist beschrieben in JACS 69(1947), 254, US-A 2 529 455 und Bl. Chem. Soc. Jap. 61 (1988) 3755-3757.

Da die Bildung der N-Hydroxymethylimide aus Formaldehyd und Imid ebenfalls unter sauer katalysierten Bedingungen erfolgt wie die Reaktion mit dem Nitril, sind beide Reaktionsstufen auch als "Eintopfverfahren" kombinierbar.

Beispiele für Monomere der Formel II sind die Umsetzungsprodukte von Acrylnitril, Methacrylnitril oder Crotonsäurenitril mit den N-Hydroxymethylderivaten von Succinimid, Phenylsuccinimid, Glutarsäureimid, Maleimid, Dimethylmaleimid, Phthalimid, Naphthalin-1,8-dicarbonsäureimid (= Benzo[de]isochinolin-1,3-dion), 2-Sulfobenzoesäureimid (= Benzo[d]isothiazol-1,1,3-trion), Acesulfam (= 6-Methyl-[1,2,3]oxathiazin-2,2,4-trion), Cyanursäure (= [1,3,5]Triazin-2,4,6-triol), Harnsäure (= Purin-2,6,8-triol), Alloxan (= Pyrimidin-2,4,5,6-tetraon) oder Parabansäure (= Imidazol-2,4,5-trion).

Weiterhin ist es möglich, die Reaktion am Polymer selbst durchzuführen, d. h. ein Polymer mit freien Nitrilgruppen durch Umsetzung mit den N-Hydroxymethylimiden zu modifizieren, wie es in Makromol. Chem. 182 (1981) 2989, beschrieben ist.

Neben den Einheiten der Formel I enthalten die Polymere bevorzugt noch weitere Einheiten, insbesondere solche, die ein acides H-Atom aufweisen, z. B. Einheiten von Sulfon-, Carbon- oder Phosphonsäuren, Sulfonamiden, Sulfon- oder Carbonimiden, und Einheiten mit phenolischen Hydroxylgruppen.

Bevorzugt sind Einheiten mit Carboxyl- oder phenolischen Hydroxylgruppen. Beispiele für entsprechende Comonomere sind o-, m- und p-Hydroxyphenyl-acrylat oder -methacrylat, o-, m- und p-Hydroxyphenyl-acrylamid oder -methacrylamid, o-, m- und p-Hydroxystyrol, 4-Hydroxy-3-methylstyrol, 4-Hydroxy-3,5-dimethyl-benzyl(meth)acrylat oder (-meth)acrylamid, Acrylsäure, Methacrylsäure, Itaconsäure, Crotonsäure und Maleinsäure.

Der Anteil an Einheiten der Formel I im Polymer liegt im allgemeinen bei 20 bis 100, bevorzugt bei 40 bis 95 Gew.-%, der Anteil an Comonomereinheiten im allgemeinen zwischen 0 und 80, bevorzugt zwischen 5 und 60 Gew.-%.

Neben den beschriebenen Einheiten können die Polymere weiterhin Einheiten enthalten, welche zur Einstellung bzw. Anpassung der Eigenschaften an spezielle Erfordernisse dienen. Beispiele für entsprechende Monomere sind Acryl- oder Methacrylsäureester wie Phenyl-, Benzyl-, Furfuryl- oder Methyl-(meth)acrylat, Amino-/Hydroxylgruppen enthaltende Ester der Acryl- und Methacrylsäure wie 2-Dimethylaminoethyl- oder 2-Hydroxyethyl-(meth)acrylat, Alkylvinylether oder -ester wie Vinylacetat oder Vinylmethylether, Styrol oder substituierte Styrole wie α-Methylstyrol oder Vinyltoluol, Acryl- oder Methacrylnitril oder -amid, ferner Vinylamide wie N-Vinylpyrrolidon und N-Methyl-N-vinylacetamid.

Weiterhin ist es möglich, geringe Mengen von bifunktionellen Monomeren wie N,N'-Methylen-bismethacrylamid oder Monomere, die zu einer thermischen Vernetzungsreaktion befähigt sind, in die Bindemittel einzupolymerisieren. Beispiele für solche Monomere sind Vertreter mit seitenständigen, aktivierten -CH₂OR-Gruppen, wie sie in der EP-A 0 184 044 (= US-A 4 699 867) beschrieben sind, Monomere mit Epoxideinheiten wie Glycidylmethacrylat oder Monomere mit seitenständigen verkappten Isocyanateinheiten.

Die Polymerisation der Monomere oder deren Copolymerisation mit anderen Monomeren läßt sich nach bekannten Methoden durchführen, z. B. in Gegenwart eines Polymerisationsinitiators wie Azo-bis-isobutyronitril oder Dibenzoylperoxid in organischen Lösemitteln bei erhöhten Temperaturen innerhalb von 1 bis 20 Stunden. Daneben ist aber auch eine Supensions-, Emulsions-, Fällungs- oder Massepolymerisation möglich, die auch durch Strahlung, Wärme oder ionische Initiatoren ausgelöst werden kann.

Erfindungsgemäß wird ferner ein lichtempfindliches Gemisch vorgeschlagen, das als wesentliche Bestandteile
a) ein in Wasser unlösliches, in wäßrig-alkalischen Lösungen lösliches oder quellbares polymeres Bindemittel und
b) ein 1,2-Chinondiazid
   enthält.

Das erfindungsgemäße Gemisch ist dadurch gekennzeichnet, daß das wasserunlösliche Bindemittel a) ein Polymer der vorstehend definierten Zusammensetzung ist.

Der Bindemittelanteil beträgt 10 bis 95 Gew.-%, bevorzugt 30 bis 80 Gew.-%, bezogen auf das Gesamtgewicht der nichtflüchtigen Bestandteile des Gemisches.

Die 1,2-Chinondiazide sind bevorzugt 1,2-Naphthochinon-2-diazid-4- oder -5-sulfonsäureester oder -amide. Von diesen sind die Ester bevorzugt. Geeignete Verbindungen dieser Art sind bekannt und zum Beispiel in der DE-C 938 233 (= GB-B 739 654) beschrieben.

Die Menge von o-Chinondiazidverbindungen beträgt im allgemeinen 3 bis 50, bevorzugt 7 bis 35 Gew.-%, bezogen auf die nichtflüchtigen Anteile des Gemischs.

Es ist auch möglich, die 1,2-Chinondiazidverbindungen in Form ihrer Sulfonsäurechloride mit den erfindungsgemäßen Polymerisaten umzusetzen, wenn diese umsetzbare Hydroxyl- oder Aminogruppen enthalten.

Die Veresterung/Amidierung der entsprechenden Säurechloride mit den Hydroxyl- oder Aminogruppen der Polymerisate erfolgt nach bekannten Verfahren (DE-A 25 07 548 = US-A 4 139 384).

Zusätzlich können noch zahlreiche andere Oligomere und Polymerisate mitverwendet werden, z. B. Phenolharze vom Novolaktyp oder Vinylpolymerisate wie Polyvinylacetale, Polymethacrylate, Polyacrylate, Polyvinylether und Polyvinylpyrrolidone, die selbst durch Comonomere modifiziert sein können.

Zur Erzeugung eines bildmäßigen Farbkontrasts, der unmittelbar nach der Belichtung erkennbar ist, können die Gemische darüber hinaus noch eine Kombination von Indikatorfarbstoffen und strahlungsempfindlichen Komponenten enthalten, die beim Belichten starke Säuren bilden, wie Phosphonium-, Sulfonium- und Jodoniumsalze, Halogenverbindungen und Organometall-Organohalogen-Kombinationen.

Die genannten Oniumverbindungen werden in der Regel in Form ihrer in organischen Lösemitteln löslichen Salze eingesetzt, meist als Abscheidungsprodukte mit komplexen Säuren wie Tetrafluoroborsäure, Hexafluorophosphor-, Hexafluoroantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, z. B. solche mit mindestens einem Halogenatom an einem Kohlenstoffatom oder an einem aromatischen Ring brauchbar (US-A 3 515 552). Von diesen Verbindungen werden die s-Triazinderivate mit Halogenmethylgruppen, insbesondere Trichlormethylgruppen, und einem aromatischen oder ungesättigten Substituenten am Triazinkern, wie sie in der DE-C-27 18 259 (= US-A 4 189 323) beschrieben sind, bevorzugt. Ebenso geeignet sind 2-Trihalogenmethyl-[1,3,4]oxadiazole. Die Wirkung dieser halogenhaltigen Verbindungen kann auch durch bekannte Sensibilisatoren spektral beeinflußt und gesteigert werden.

Die Menge des photochemischen Säurespenders kann, je nach seiner chemischen Natur und der Zusammensetzung der Schicht, ebenfalls sehr verschieden sein. Günstige Ergebnisse werden erhalten mit etwa 0,1 bis 10 Gew.-%, bezogen auf das Gesamtgewicht der nichtflüchtigen Bestandteile.

Als Indikatorfarbstoffe haben sich die kationischen Farbstoffe wie Triphenylmethanfarbstoffe, insbesondere in der Form ihrer Carbinolbasen, und die Methinfarbstoffe besonders bewährt.

Ferner können dem strahlungsempfindlichen Gemisch noch lösliche oder auch feinteilige dispergierbare Farbstoffe sowie UV-Absorber, Tenside, Polyglykolderivate und Pigmente zugesetzt werden. Die günstigsten Mengenverhältnisse der Komponenten lassen sich im Einzelfall durch Vorversuche leicht ermitteln.

Erfindungsgemäß wird schließlich noch ein lichtempfindliches Aufzeichnungsmaterial mit einem Schichtträger und einer lichtempfindlichen Schicht vorgeschlagen, das dadurch gekennzeichnet ist, daß die lichtempfindliche Schicht aus einem Gemisch der vorstehenden Zusammensetzung besteht.

Zur Beschichtung eines geeigneten Schichtträgers werden die Gemische im allgemeinen in einem Lösemittel gelöst. Die Wahl der Lösemittel ist auf das vorgesehene Beschichtungsverfahren, die Schichtdicke und die Trocknungsbedingungen abzustimmen. Geeignet für das erfindungsgemäße Gemisch sind insbesondere stark polare Lösemittel wie Dimethylsulfoxid, Tetramethylensulfon (Sulfolan), N-Methylpyrrolidon, N-Hydroxyethylpyrrolidon, Dimethylformamid, Dimethylacetamid, Butyrolacton, Aceto- oder Butyronitril, 2-Nitropropan oder Nitromethan, Ethylen- oder Propylencarbonat. Bevorzugt werden diese Lösemittel im Gemisch mit Ketonen wie Aceton oder Methylethylketon, chlorierten Kohlenwasserstoffen wie Trichlorethylen oder 1,1,1-Trichlorethan, Alkoholen wie Methanol, Ethanol oder Propanol, Ethern wie Tetrahydrofuran, Alkoholethern wie Ethylen- oder Propylenglykolmonomethylether und Estern wie Methyl- oder Ethylacetat, Ethylen- oder Propylenglykolmethyletheracetat verwendet. Prinzipiell sind alle Lösemittel oder Lösemittelmischungen verwendbar, die mit den Schichtkomponenten nicht irreversibel reagieren.

Als Schichtträger für Schichtdicken unter ca. 10 mm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z. B. mit Polymerisaten oder Polykondensaten, die Einheiten mit Phosphon-, Carbon- oder Sulfonsäuregruppen aufweisen und weiterhin Einheiten aus Monomeren mit basischen Einheiten, z. B. Aminogruppen, enthalten können, ferner mit Silikaten, Phosphaten, Fluoriden oder Fluorokomplexen vorbehandelt sein kann. Auch sind Kombinationen solcher Vorbehandlungen möglich.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlenbogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen, verwendet werden, die als Strahlungsquelle z. B. einen Argon- oder Krypton-Ionen-Laser enthalten.

Die Bestrahlung kann ferner mit Elektronenstrahlen erfolgen. In diesem Falle können auch in dem obengenannten Spektralbereich nicht lichtempfindliche, Säure bildende Verbindungen als Initiatoren der Solubilisierungsreaktion eingesetzt werden, z. B. halogenierte aromatische Verbindungen oder halogenierte polymere Kohlenwasserstoffe. Auch Röntgenstrahlen können zur Bilderzeugung verwendet werden.

Die bildmäßig belichteten oder bestrahlten Schichtbereiche können in bekannter Weise mit praktisch den gleichen Entwicklern, wie sie für handelsübliche Naphthochinondiazid-Druckplatten bekannt sind, entfernt werden. Die erfindungsgemäßen Materialien können in ihrem Kopierverhalten mit Vorteil auf die bekannten Entwickler und programmierten Sprühentwicklungsgeräte abgestimmt werden. Die wäßrigen Entwicklerlösungen können zum Beispiel Alkaliphosphate, -silikate oder -hydroxide und ferner Netzmittel sowie gegebenenfalls kleinere Anteile organischer Lösemittel enthalten. In bestimmten Fällen sind auch Lösemittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Weiterhin kann das erfindungsgemäße Aufzeichnungsmaterial nach der bildmässigen Belichtung und Entwicklung mit einer wäßrig-alkalischen Entwicklerlösung - gegebenenfalls nach Überziehen mit einem hydrophilen Schutzfilm oder einer Einbrenngummierung - auf erhöhte Temperatur erwärmt werden, um die Bild- bzw. Druckschablone weiter zu verfestigen. Dabei wird das bebilderte strahlungsempfindliche Aufzeichnungsmaterial im allgemeinen 0,5 bis 60 min auf eine Temperatur im Bereich von 150 bis 280 °C erwärmt.

Im folgenden werden Beispiele für bevorzugte Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

### Synthesebeispiel für Monomere entsprechend Formel II

1,5 mol Imid und 1,5 mol Paraformaldehyd wurden in 1 l siedendem Eisessig innerhalb 1,5 h zum N-Hydroxymethyl-imid umgesetzt. Nach Abkühlen auf 25 °C wurden zunächst 1,3 l konzentrierte Schwefelsäure, dann 1,5 mol ungesättigtes Nitril zugegeben. Die Reaktionslösung wurde 30 min bei 80 °C gerührt und nach Abkühlung auf 25 °C in 12 l Eiswasser getropft, wobei das Produkt ausfiel. Das Rohprodukt wurde nacheinander mit Kochsalzlösung, Natriumhydrogencarbonatlösung und Wasser gewaschen und dann bei 53 mbar im Vakuum bei 40 °C getrocknet. Ausbeuten ca. 80 bis 90 %.

Nach dieser Vorschrift wurden erhalten :
- Monomer 1:: N-Acryloylaminomethyl-phthalimid aus Phthalimid und Acrylnitril
- Monomer 2:: N-Methacryloylaminomethyl-phthalimid aus Phthalimid und Methacrylnitril
- Monomer 3:: N-Acryloylaminomethyl-benzo[d]isothiazol-1,1,3-trion aus Saccharin und Acrylnitril
- Monomer 4:: N-Methacryloylaminomethyl-benzo[d]isothiazol-1,1,3-trion aus Saccharin und Methacrylnitril.

### Synthesebeispiel für Polymere mit Monomereinheiten entsprechend Formel I

Die Monomere wurden in einem der obengenannten stark polaren Lösemittel zu einer Lösung mit einem Feststoffgehalt von 30 Gew.-% gelöst. Diese wurde auf 80 °C erhitzt und unter Stickstoff wurden 3 mol-% Azobis-isobutyronitril (AIBN), bezogen auf das gesamte Monomerengemisch, innerhalb 1 h zugegeben. Die Lösungen wurden noch ca. 7 h bei dieser Temperatur gehalten. Es resultierten Polymere mit reduzierten spezifischen Viskositäten von 0,1 bis 0,3 dl/g [0,1%ig in Dimethylformamid (DMF)].

Mit den Monomeren entsprechend Tabelle 1 wurden nach dieser Vorschrift die in Tabelle 2 aufgeführten Polymere erhalten.

**Tabelle 1**

| **Monomer Nr.** | **Chemische Bezeichnung** |
|---|---|
| 1 | N-Acryloylaminomethyl-phthalimid |
| 2 | N-Methacryloylaminomethyl-phthalimid |
| 3 | N-Acryloylaminomethyl-benzo[d]isothiazol-1,1,3-trion |
| 4 | N-Methacryloylaminomethyl-benzo[d]isothiazol-1,1,3-trion |
| 5 | 2-Hydroxy-phenylmethacrylat |
| 6 | N-(4-Hydroxy-phenyl)-methacrylamid |
| 7 | N-(4-Sulfamoyl-phenyl)-methacrylamid |
| 8 | Acrylsäure |
| 9 | 4-Hydroxy-3,5-dimethyl-benzyl-methacrylamid |
| 10 | 4-Hydroxy-styrol |
| 11 | Methylmethacrylat |
| 12 | Styrol |
| 13 | Methacrylamid |

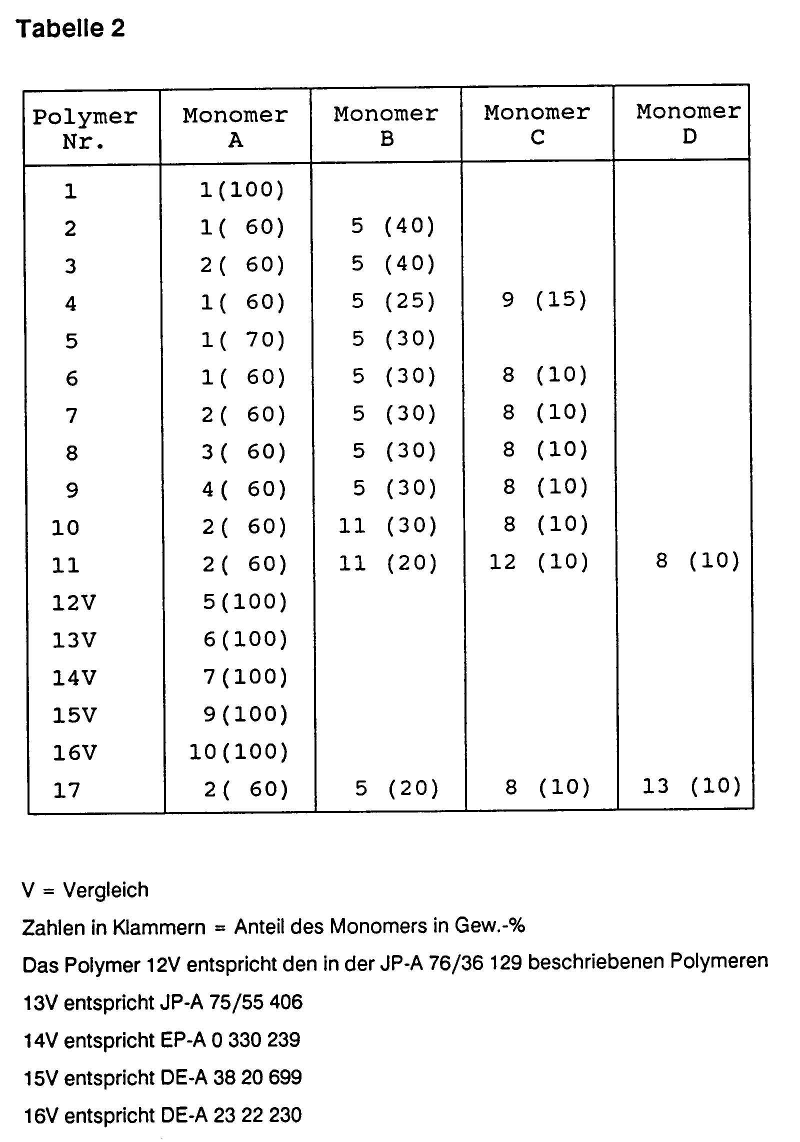

### Beispiel 1

Eine in Salzsäure elektrolytisch aufgerauhte (RZ-Wert nach DIN 4768: 5,0 µm), in Schwefelsäure zwischengebeizte und anodisierte (Oxidgewicht 3,5 g/m²) und mit Polyvinylphosphonsäure hydrophilierte, 0,3 mm starke Aluminiumfolie wurde mit folgender Lösung schleuderbeschichtet:
- 6,0 Gt: eines Polymers gemäß Tabelle 2
- 2,2 Gt: des Veresterungsprodukts aus 1,5 mol 1,2-Naphthochinon-2-diazid-5-sulfonylchlorid und 1 mol 2,3,4-Trihydroxybenzophenon
- 0,3 Gt: 1,2-Naphthochinon-2-diazid-4-sulfonylchlorid
- 0,2 Gt: Victoriareinblau (C.I. 44 045)
- 0,6 Gt: 1,1,1-Tris-(4-hydroxyphenyl)-ethan
- 0,1 Gt: eines Kieselgels einer mittleren Korngröße von 4 µm als Füllstoff
- 0,01 Gt: eines Dimethylsiloxan-Ethylenoxid-Propylenoxid-Copolymers
- ad 100 Gt: Gemisch aus Tetrahydrofuran und Dimethylsulfoxid (65:35)
und bei 110 °C getrocknet. Die Schichtgewichte (SG) in g/m² sind in Tabelle 3 angegeben.

### Verarbeitung der gefertigten Druckplatten

Die Druckplatten wurden unter einer 5-kW-Metallhalogenidlampe im Abstand von 110 cm durch eine Standard-Positiv-Testvorlage mit Halbton-Stufenkeilen (continuous tone step wedge) und Raster-Stufenkeilen (halftone step wedge) 100 s belichtet und 60 s in folgendem Entwickler entwickelt:

### Entwickler:

- 0,4 mol/l: Na₂SiO₃
- 1 %: Natriumbenzoat
- 0,1 %: eines Ethylenoxid/Propylenoxid-Copolymers mit dem Molekulargewicht 1 600
- Rest: Wasser

Die Lichtempfindlichkeit (LE) wurde anhand der ersten offenen Stufe des Halbtonstufenkeils beurteilt, die Wiedergabe bzw. Auflösung (AV) anhand der Anzahl der vollständig wiedergegebenen Felder des 60er-Rasters der Testvorlage, siehe Tabelle 3.

### Stabilität gegen Auswaschmittel für UV-härtbare Druckfarben (UV)

Die belichtete und entwickelte Platte wurde 60 s in einer Küvette einem Auswaschmittel auf Alkohol-Glykolether/Glykolester-Basis (UV-Waschmittel W 936 von Zeller & Gmelin) ausgesetzt und anschließend die Bildschädigung visuell beurteilt:
- + =: kein oder schwacher Angriff
- 0 =: mittlerer Angriff
- - =: starker Angriff oder vollständiger Schichtabtrag

### Thermisches Vernetzungsverhalten (TD)

Die Platten wurden nach Aufbringen einer handelsüblichen Einbrenngummierung (RC 514 der Hoechst AG) bei 250 °C in einem Lacktrockenschrank 8 min eingebrannt. Mit Dimethylformamid wurde die Resistenz der eingebrannten Platten gegen stark polare Lösemittel geprüft:
- + =: schwacher oder kein Angriff
- - =: starker Angriff oder vollständiger Schichtabtrag

### Druckauflagen (DrA)

Von einer Reihe dieser Platten wurde im nicht thermisch gehärteten Zustand die Druckauflage in einer Bogenoffsetmaschine ermittelt. Tabelle 3 gibt die Ergebnisse wieder (DrA in 1 000).

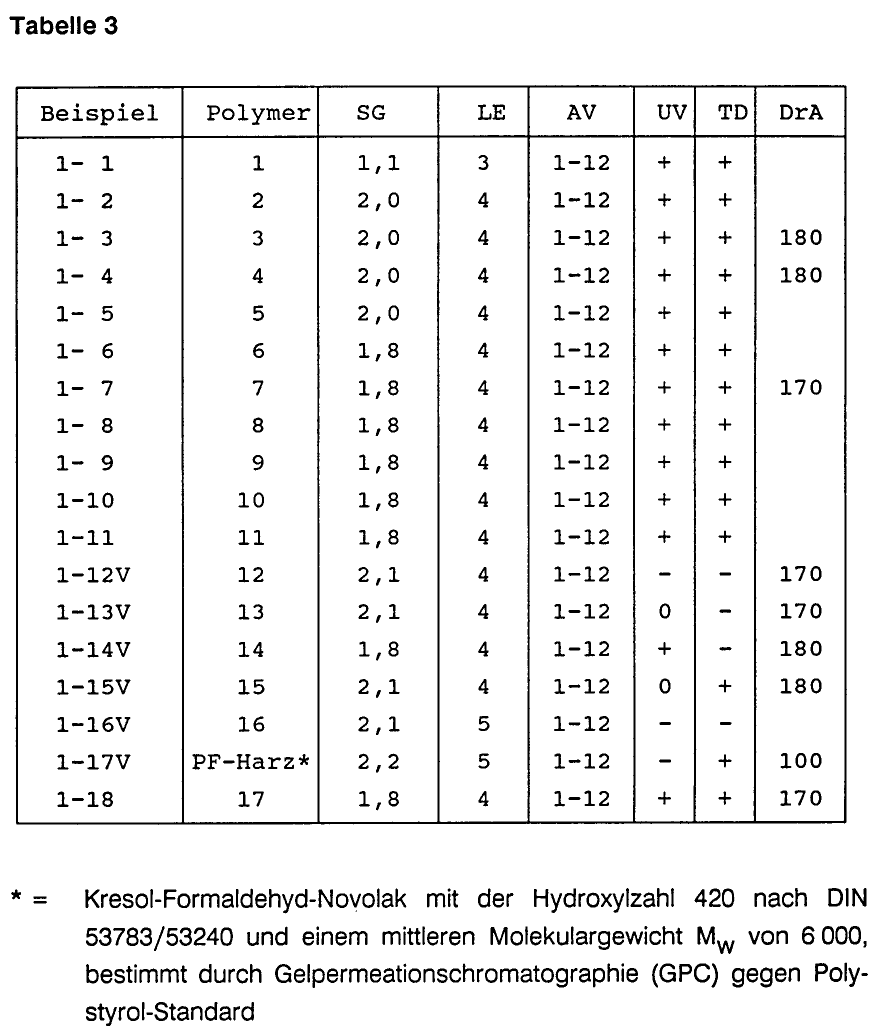

Die Ergebnisse zeigen, daß mit erfindungsgemäßen Polymerisaten hergestellte Druckplatten eine höhere Druckauflage als herkömmliche Positivdruckplatten mit Novolaken als Bindemittel ergeben, daß sie stabil gegen Auswaschmittel sind und daß sie durch thermische Nachhärtung auch gegen stark polare Lösemittel resistent werden.

### Beispiel 2

Eine in Salpetersäure elektrolytisch aufgerauhte (RZ-Wert nach DIN 4768: 4,5 µm), in Schwefelsäure zwischengebeizte und anodisierte (Oxidgewicht 3,0 g/m²), mit N-Phosphonomethyl-polyethylenimin und mit Polyvinylphosphonsäure entsprechend der älteren deutschen Patentanmeldung P 44 23 140.7 hydrophilierte Aluminiumfolie von 0,28 mm Stärke wurde mit folgender Lösung schleuderbeschichtet:
- 7,0 Gt: eines Polymers gemaß Tabelle 4
- 1,8 Gt: eines Veresterungsprodukts aus 3,4 mol 1,2-Naphthochinon-2-diazid-4-sulfonylchlorid und 1 mol Bis-(2,3,4-Trihydroxy-5-benzoyl-phenyl)methan
- 0,2 Gt: 2-(4-Styryl-phenyl)-4,6-bis-trichlormethyl-s-triazin
- 0,18 Gt: Victoriareinblau
- 0,7 Gt: Bis-(4-hydroxyphenyl)-sulfon
- 0,1 Gt: des Kieselgels von Beispiel 1
- 0,01 Gt: eines Dimethylsiloxan-Ethylenoxid-Propylenoxid-Copolymers
- ad 100 Gt: Gemisch aus Tetrahydrofuran und Butyrolacton (65:35)
und bei 110 °C getrocknet. Schichtgewichte: einheitlich 1,7 g/m²

### Verarbeitung der gefertigten Druckplatten

Die Druckplatten wurden unter einer 5-kW-Metallhalogenidlampe im Abstand von 110 cm durch eine Standard-Negativ-Testvorlage mit Halbton- und Rasterelementen wie in Beispiel 1 angegeben 50 s belichtet, 1,5 min bei 135 °C getempert, nach Kühlung in einem Wasserbad ganzflächig ohne Vorlage mit einer UV-A-Leuchtstofflampe ausbelichtet und 60 s in folgendem Entwickler entwickelt:

### Entwickler:

- 0,45 mol/l: K₂SiO₃
- 1 %: Natriumcumolsulfonat
- 0,1 %: Polyglykol-1000-dicarbonsäure
- 0,01 %: Natrium-Propylendiamintetraacetat
- Rest: Wasser

### Prüfung und Bewertung der im Umkehrverfahren verarbeiteten Platten

Die Lichtempfindlichkeit und die Wiedergabe, die Auswaschstabilität, das Nachhärtungsverhalten und die Druckauflage wurden wie in Beispiel 1 beurteilt.

Tabelle 4 gibt die Ergebnisse wieder.

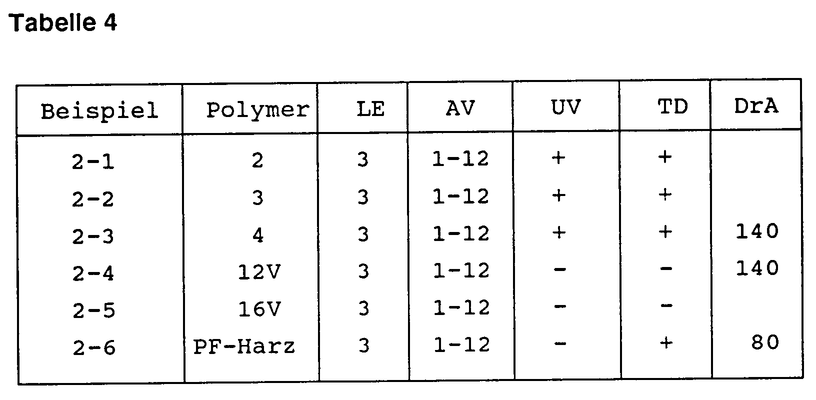

### Beispiel 3

Eine zunächst mechanisch, dann in Salzsäure elektrolytisch aufgerauhte (RZ-Wert nach DIN 4768: 6,0 µm), in Schwefelsäure zwischengebeizte und anodisierte (Oxidgewicht 4,0 g/m²) und mit Polyvinylphosphonsäure hydrophilierte Aluminiumfolie von 0,4 mm Stärke wurde mit folgender Lösung schleuderbeschichtet:
- 6,5 Gt: eines Polymers gemäß Tabelle 5
- 2,3 Gt: des Veresterungsprodukts aus 3,6 mol 1,2-Naphthochinon-2-diazid-5-sulfonylchlorid und 1 mol Bis-(5-acetyl-2,3,4-trihydroxy-phenyl)-methan
- 0,4 Gt: 1,2-Naphthochinon-2-diazid-4-sulfonylchlorid
- 0,5 Gt: 2,4-Dihydroxy-benzophenon
- 0,09 Gt: Kristallviolettbase (C.I. 42 555:1)
- ad 100 Gt: Gemisch aus Aceton und Dimethylacetamid (70:30)
und bei 110 °C getrocknet. Die Schichtgewichte sind in Tabelle 5 angegeben.

Auf diese lichtempfindlichen Schichten wurde dann entsprechend der älteren deutschen Patentanmeldung P 43 35 425.4 als Mattierungsschicht eine anionisch stabilisierte Dispersion eines Methacrylsäure-Methylmethacrylat-Ethylacrylat-Copolymers mit einem Methacrylsäuregehalt von 6,1 Gew.-% elektrostatisch aufgesprüht, so daß eine mittlere Kalottenhöhe von 4 µm, ein mittlerer Kalottendurchmesser von 30 µm und eine Kalottendichte von ca. 2000/cm² resultierte.

Die Platten wurden wie in Beispiel 1 belichtet und entwickelt.

### Entwickler:

- 0,12 mol/l: Na₂Si₃O₇
- 0,48 mol/l: KOH
- 0,5 %: Natriumpelargonat
- 0,1 %: Nonylphenolpolyethylenglykolether mit 10 Ethylenoxideinheiten
- 0,01 %: Siliconentschäumer (EC31 der Hoechst AG)
- Rest: Wasser

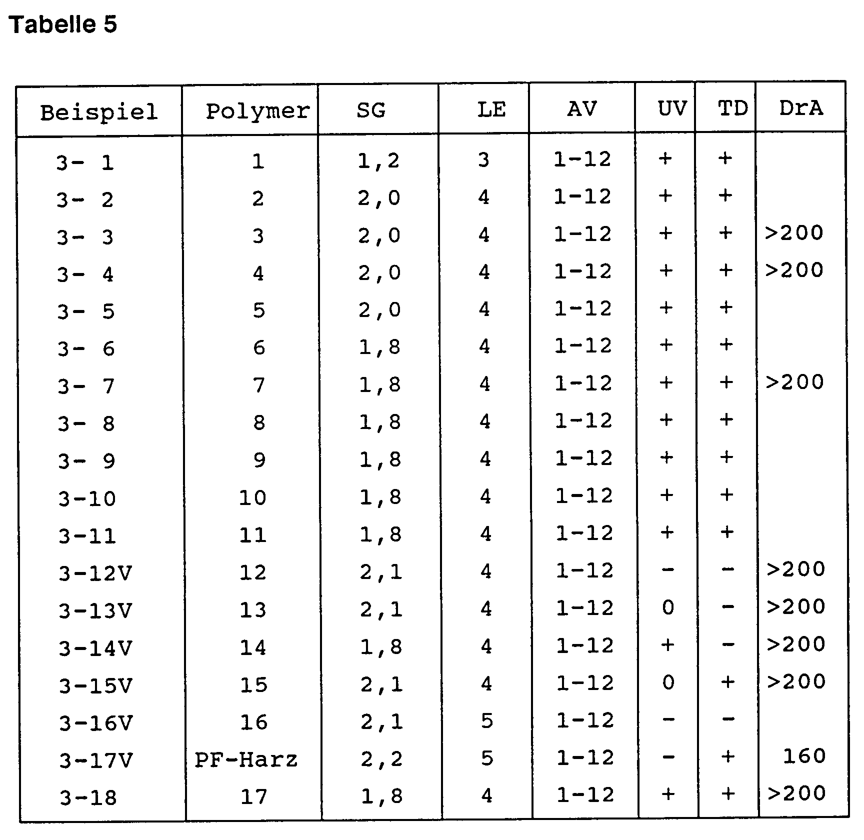

## Patentansprüche

1. Polymer mit wiederkehrenden Einheiten der allgemeinen Formel I 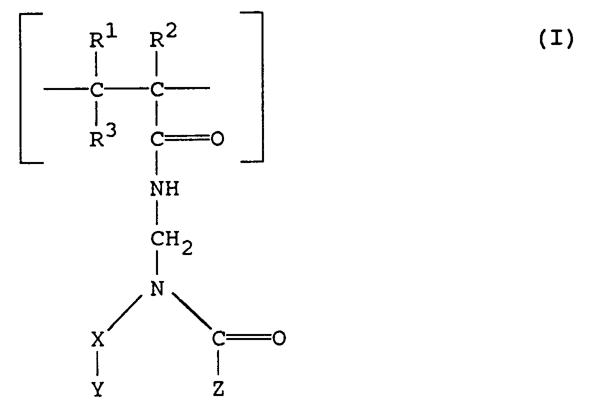 worin
R¹,R² und R³ unabhängig voneinander Wasserstoffatome oder Alkylgruppen sind,
X CO oder SO₂ ist und
Y und Z unabhängig voneinander Alkyl-, Alkenyl-, Cycloalkyl-, Aryl- oder (un)gesättigte heterocyclische Reste bedeuten, wobei Y und Z miteinander verknüpft und Bestandteile eines fünf- oder sechsgliedrigen heterocyclischen Rings sein können.

2. Polymer nach Anspruch 1, dadurch gekennzeichnet, daß R¹ und R³ Wasserstoffatome sind.

3. Polymer nach einem der Ansprüche 1 und 2, dadurch gekennzeichnet, daß R² eine Methylgruppe ist.

4. Polymer nach Anspruch 1, dadurch gekennzeichnet, daß Y und Z zu einem fünfgliedrigen Ring verknüpft sind, an den ein weiterer Ring anelliert ist.

5. Polymer nach Anspruch 4, dadurch gekennzeichnet, daß der weitere Ring ein Benzolring ist.

6. Polymer nach Anspruch 1, dadurch gekennzeichnet, daß es außer den Einheiten der Formel I weitere Einheiten enthält, die acide Wasserstoffatome aufweisen.

7. Polymer nach Anspruch 6, dadurch gekennzeichnet, daß die Einheiten mit aciden Wasserstoffatomen von Sulfon-, Carbon- oder Phosphonsäuren, Sulfonsäureamiden, Sulfon- oder Carbonsäureimiden oder Phenolen abgeleitet sind.

8. Polymer nach Anspruch 1 oder 6, dadurch gekennzeichnet, daß es zu 20 bis 100 Gew.-% aus Einheiten der Formel I besteht.

9. Verfahren zur Herstellung eines Polymers gemäß Anspruch 1, dadurch gekennzeichnet, daß man ein ungesättigtes Nitril der Formel 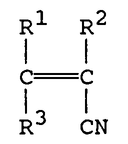 mit einem N-Hydroxymethyl-imid der Formel 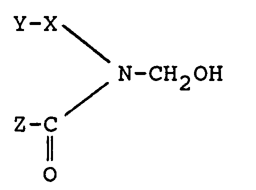 in Gegenwart einer Säure zu einem Monomer der Formel II 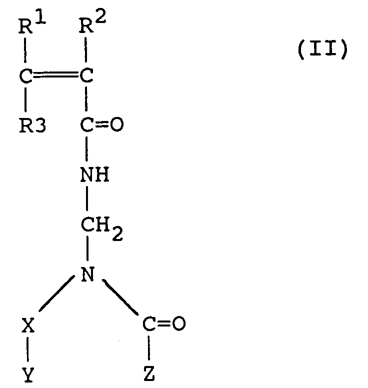 umsetzt und das Monomer in üblicher Weise in Gegenwart eines radikalbildenden Katalysators zum Polymer mit Einheiten der Formel I polymerisiert, wobei alle Symbole die in Anspruch 1 angegebene Bedeutung haben.

10. Lichtempfindliches Gemisch, das als wesentliche Bestandteile
a) ein in Wasser unlösliches, in wäßrig-alkalischen Lösungen lösliches oder quellbares polymeres Bindemittel und
b) ein 1,2-Chinondiazid
enthält, dadurch gekennzeichnet, daß das wasserunlösliche Bindemittel a) ein Polymer gemäß einem der Ansprüche 1 bis 8 ist.

11. Lichtempfindliches Aufzeichnungsmaterial mit einem Schichtträger und einer lichtempfindlichen Schicht, dadurch gekennzeichnet, daß die lichtempfindliche Schicht aus einem Gemisch gemäß Anspruch 10 besteht.

## Claims

1. A polymer with repeating units of the general formula I 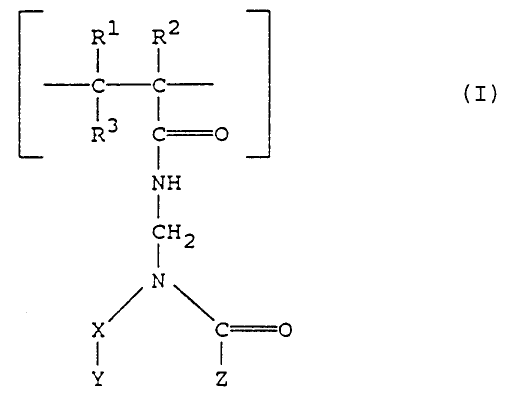 in which
R¹, R² and R³ independently of each other, represent hydrogen atoms or alkyl groups,
X represents CO or SO₂ and
Y and Z independently of each other, represent alkyl, alkenyl, cycloalkyl, aryl or (un)saturated heterocyclic groups, wherein Y and Z may be linked to each other and are then constituents of a five or six-membered ring.

2. A polymer according to Claim 1, characterised in that R¹ and R³ are hydrogen atoms.

3. A polymer according to one of Claims 1 and 2, characterised in that R² is a methyl group.

4. A polymer according to Claim 1, characterised in that Y and Z are linked to form a five-membered ring to which a further ring is fused.

5. A polymer according to Claim 4, characterised in that the further ring is a benzene ring.

6. A polymer according to Claim 1, characterised in that it contains, in addition to the units of the formula I, further units which have acidic hydrogen atoms.

7. A polymer according to Claim 6, characterised in that the units with acidic hydrogen atoms are derived from sulfonic, carboxylic or phosphonic acids, sulfonic acid amides, sulfonic or carboxylic acid imides or phenols.

8. A polymer according to Claim 1 or 6, characterised in that 20 to 100 wt.% of the units contained therein are of the formula I.

9. A process for preparing a polymer according to Claim 1, characterised in that an unsaturated nitrile of the formula 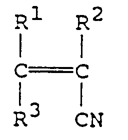 is reacted with an N-hydroxymethyl imide of the formula 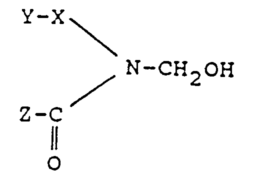 in the presence of an acid to give a monomer of the formula II 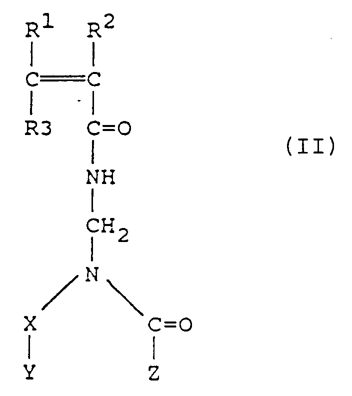 and the monomer is polymerised in a conventional manner in the presence of a radical-producing catalyst to give a polymer with units of the formula I, wherein all the symbols have the same meaning as given in Claim 1.

10. A photosensitive mixture which contains, as substantial constituents,
a) a polymeric binder which is insoluble in water and is soluble or swellable in aqueous alkaline solutions and
b) a 1,2-quinone diazide,
characterised in that the water-insoluble binder a) is a polymer in accordance with one of Claims 1 to 8.

11. A photosensitive recording material with a backing layer and a photosensitive layer, characterised in that the photosensitive layer consists of a mixture in accordance with Claim 10.

## Revendications

1. Polymère avec les unités récurrentes de formule générale (I) : 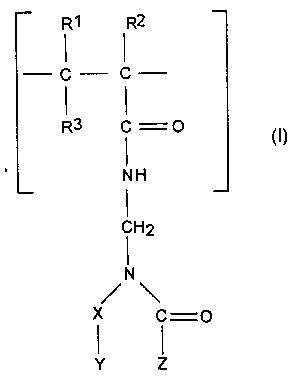 où
R¹, R² et R³ sont, indépendamment l'un de l'autre, un atome d'hydrogène ou un radical alcoyle ;
X est CO ou SO₂, et
Y et Z représentent, indépendamment l'un de l'autre, des radicaux alcoyle, alcényle, cycloalcoyle, aryle ou hétérocycliques (in)saturés, où Y et Z peuvent être reliés l'un à l'autre et être les constituants d'un hétérocycle à 5 ou 6 membres.

2. Polymère suivant la revendication 1, caractérisé en ce que R¹ et R³ sont des atomes d'hydrogène.

3. Polymère suivant l'une quelconque des revendications 1 et 2, caractérisé en ce que R² est un radical méthyle.

4. Polymère suivant la revendication 1, caractérisé en ce que Y et Z sont reliés en un cycle à 5 membres, sur lequel un autre cycle est condensé.

5. Polymère suivant la revendication 4, caractérisé en ce que l'autre cycle est un cycle benzénique.

6. Polymère suivant la revendication 1, caractérisé en ce qu'il contient, en plus des unités de formule (I), d'autres unités qui présentent un atome d'hydrogène acide.

7. Polymère suivant la revendication 6, caractérisé en ce que les unités avec un atome d'hydrogène acide dérivent des acides sulfonique, carboxylique ou phosphonique, des sulfonamides, des sulfon- ou carbonimides ou des phénols.

8. Polymère suivant la revendication 1 ou 6, caractérisé en ce qu'il consiste en 20 à 100% en poids d'unités de formule (I).

9. Procédé de préparation d'un polymère suivant la revendication 1, caractérisé en ce que l'on fait réagir un nitrile insaturé de formule : 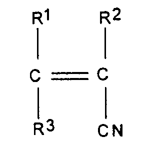 avec un N-hydroxyméthylimide de formule : 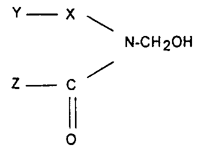 en présence d'un acide, pour donner un monomère de formule (II) : 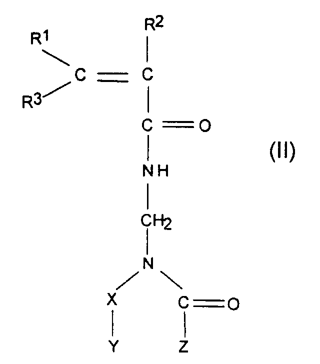 et que le monomère est polymérisé, de manière classique, en présence d'un catalyseur radicalaire, en un polymère ayant les unités de formule (I), où tous les symboles ont la signification donnée à la revendication 1.

10. Composition photosensible, qui contient comme constituants essentiels :
a) un liant polymère insoluble dans l'eau, soluble ou gonflable dans les solutions aqueuses alcalines, et
b)un 1,2-quinonediazide,
caractérisé en ce que le liant insoluble dans l'eau a) est un polymère suivant l'une quelconque des revendications 1 à 8.

11. Matériau d'inscription photosensible avec un support de couche et une couche photosensible, caractérisé en ce que la couche photosensible consiste en une composition suivant la revendication 10.
